(19) Europäisches Patentamt
European Patent Office
Office européen des brevets

(11) **EP 2 764 647 B1**

(12) **EUROPÄISCHE PATENTSCHRIFT**

(45) Veröffentlichungstag und Bekanntmachung des Hinweises auf die Patenterteilung:
**13.02.2019   Patentblatt 2019/07**

(21) Anmeldenummer: **12809188.1**

(22) Anmeldetag: **13.12.2012**

(51) Int Cl.:
***H04L 1/00*** *(2006.01)*

(86) Internationale Anmeldenummer:
**PCT/EP2012/075387**

(87) Internationale Veröffentlichungsnummer:
**WO 2013/087771 (20.06.2013 Gazette 2013/25)**

(54) **VERFAHREN ZUR BILDUNG EINES CRC-WERTES SOWIE SENDE- UND EMPFANGSVORRICHTUNG HIERFÜR**

METHOD FOR FORMING A CRC VALUE AND TRANSMITTING AND RECEIVING APPARATUS THEREFOR

PROCÉDÉ PERMETTANT D'OBTENIR UNE VALEUR DE CRC AINSI QUE DISPOSITIF D'ÉMISSION ET DE RÉCEPTION ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.12.2011   DE 102011121141**

(43) Veröffentlichungstag der Anmeldung:
**13.08.2014   Patentblatt 2014/33**

(73) Patentinhaber: **Siemens Aktiengesellschaft 80333 München (DE)**

(72) Erfinder:
• **GEORGIADES, Jean 80805 München (DE)**
• **PREMKE, Markus 93055 Regensburg (DE)**
• **WIESGICKL, Bernhard 92249 Vilseck (DE)**

(56) Entgegenhaltungen:
**EP-A2- 0 757 455          DE-A1-102007 016 917 US-A1- 2004 250 061**

EP 2 764 647 B1

**Beschreibung**

Die Erfindung betrifft ein Verfahren zur Bildung eines CRC-Wertes gemäß Patentanspruch 1 sowie eine Sendevorrichtung gemäß Patentanspruch 6 und eine Empfangsvorrichtung gemäß Patentanspruch 7.

Eine gängige Methode zum Erkennen von Fehlern bei einer Datenübertragung oder -speicherung, insbesondere zum Integritätsschutz einer Nachricht M bei einer Übertragung, ist der Schutz der Daten mittels zyklischer Redundanzprüfung, häufig auch als "CRC"-Schutz (CRC = Cyclic Redundancy Check) bezeichnet.

Im Fall einer Nachricht M der Länge r Bits wird diese als ein Polynom f(x) mod 2 vom Grad (n+r-1) betrachtet. Die höheren r x-Potenzen von f(x) (also von $x^{(n+r-1)}$ bis $x^n$) stellen die Nachricht M dar, die niederen n x-Potenzen von f(x) (also von $x^{(n-1)}$ bis $x^0$) stellen den CRC-Teil dar. Diese n Bits werden so bestimmt, dass das Polynom f(x) ein Vielfaches eines vorher bestimmten Polynoms g(x) mod 2 vom Grad n ist. Das Polynom g(x) heißt Generatorpolynom des (n,r)-CRC-Codes. Der Sender S der Nachricht M überträgt an den Empfänger R das Polynom f(x). Der Empfänger R erhält ein Polynom h(x) (wenn das Polynom fehlerfrei angekommen ist, dann ist h(x) =f(x)). R führt einen Integritätstest durch, indem er das empfangene Polynom h(x) durch das Generatorpolynom g(x) dividiert (Division mod 2).

Ist der Rest nach der Division von Null verschieden, dann ist es sicher, dass während der Übertragung Fehler passiert sind. Ist der Rest nach der Division gleich Null, dann ist mit großer Wahrscheinlichkeit die Nachricht M richtig angekommen, es sei denn es sind mit einer gewissen Restfehlerwahrscheinlichkeit Bitfehler an speziellen Stellen aufgetreten, dass das empfangene Polynom h(x) verschieden von f(x) ist und trotzdem die Polynomdivision mod 2 von h(x) durch g(x) den Rest Null liefert.

Je nach Größe der Zahlen n und r und der Darstellung des Polynoms g(x) gibt es eine maximale Zahl HD(n, r, g(x)) = k, mit der Eigenschaft, dass die Polynomdivision einen Rest ungleich Null liefert, wenn bis zu k-1 Fehlern passiert sind (Umgekehrt heißt es, dass es mindestens eine Kombination aus einer Anzahl von k Fehlern gibt, bei der die Polynomdivision den Rest Null zurückgibt). In der Codierungstheorie steht HD für den Begriff "Hamming-Distance". Je größer die HD ist, desto niedriger ist die Restfehlerwahrscheinlichkeit, dass bei einem Restergebnis "Null" nach der Polynomdivision, doch eine fehlerhafte Nachricht beim Empfänger angekommen ist.
Beispiel:

$$HD(8,\ 9,\ x^8+\ x^7+\ x^6+\ x^4+\ x^2+x+1)\ =\ 5.$$

Zunächst heißt es, dass eine Nachricht M der Länge 9 Bits in ein Polynom f(x) mod 2 vom Grade 8 + 9 -1 = 16 so transformiert wird, dass die führenden 9 x-Potenzen von f(x) die Nachricht M repräsentieren und die Koeffizienten der niederen 8 x-Potenzen so gewählt sind, dass f(x) ein Vielfaches von g(x) = $x^8+x^7+x^6+x^4+x^2+x+1$ ist. Dabei bedeutet der Wert "HD()=5", dass bei der Polynomdivision des empfangenen Polynoms h(x) durch g(x) mit absoluter Sicherheit bis zu 5 - 1 = 4 Fehlern erkannt werden und der Divisionsrest in so einem Fall nie gleich Null sein wird.

Die Nachricht M besteht hierbei aus verschiedenen Blöcken $A_1$, $A_2$...$A_k$ und $B_1$, $B_2$,...$B_t$, dabei beträgt die Länge aller "A"-Blöcke zusammen $r_A$ Bits und die der "B"-Blöcke $r_B$ Bits mit $r_A + r_B = r$. Allerdings werden dem Empfänger R nur die "B"-Blöcke und die CRC-Bits übertragen, da der Text der "A"-Blöcke dem Empfänger R bekannt sein sollte. Dies bedeutet, dass die "A"- und die "B"-Blöcke bei der Bestimmung der CRC-Bits vom Sender S berücksichtigt werden, anschließend werden aber diese "A"-Blöcke an den Empfänger R nicht übertragen.

Die Reihenfolge der Blöcke ist nicht fest, aber jedoch beiden Teilnehmern bekannt. Ferner sollte in gewissen Fällen auch beachtet werden, dass die maximale Anzahl der zu sendenden Bits eine obere Grenze $b_{MAX}$ nicht überschreiten soll ($b_{MAX}$ könnten z.B. 2 oder 4 Bytes sein). Um einen maximalen Integritätsschutz zu erreichen, kann daher bei der Bildung des Polynoms f(x) bzw. bei der Bildung der CRC-Bits ein Generatorpolynom g(x) verwendet werden, für welches gelten soll:

$$n\ +\ r_B\ \leqslant\ b_{MAX}\ +1$$

und

HD(n, $r_B$, g(x)) soll maximal sein.

Nach dem Empfang der B-Blöcke und der CRC-Bits konstruiert der Empfänger R mit diesen Daten und mit den ihm bekannten "A"-Blöcken das Polynom h(x) und testet es mittels der Polynomdivision mod 2 durch g(x) (s.o.)

US 2004/250061 A1 (Yamauchi Hiroki et al.) 09. Dezember 2004 beschreibt ein Verfahren gemäß dem Oberbegriff von Anspruch 1, wobei die Datenblöcke, die nicht an den Empfänger übertragen werden bzw. wurden, nur dem Empfänger und dem Sender bekannte geheime Informationen sind.

DE 10 2007 016917 A1 (Phoenix Contact GmbH & Co) 09. Oktober 2008 beschreibt ein Verfahren in einem Feldbus-Kommunikationssystem, bei dem zur Berechnung des CRC-Wertes Datenblöcke einbezogen werden, die nicht an den Empfänger übertragen werden. Allerdings wird nicht die für die Bildung des CRC-Wertes vorteilhafte Anordnung dieser Datenblöcke vor den Datenblöcken, die an den Empfänger übertragen werden, offenbart.

Ausgehend hiervon ist es Aufgabe vorliegender Erfindung, den CRC-Schutz noch weiter zu verbessern.

Die Lösung dieser Aufgabe gelingt durch ein Verfahren gemäß Patentanspruch 1. Vorteilhafte Ausgestaltungen dieses Verfahrens sind Gegenstand der Unteransprüche 2 bis 4 und 10.

Der Erfindung liegt dabei die Erkenntnis zugrunde, dass die Reihenfolge der "A"- bzw. "B"-Blöcke bei der Bildung des Polynoms f(x) die Qualität des Schutzes beeinflusst.

Auf Seite eines Senders werden bei dem erfindungsgemäßen Verfahren zur Bildung eines CRC-Wertes Datenblöcke, die nicht an einen Empfänger übertragen werden, vor Datenblöcken, die an den Empfänger übertragen werden, platziert.

Auf Seite eines Empfängers werden bei dem erfindungsgemäßen Verfahren zur Bildung eines CRC-Wertes Datenblöcke, die nicht an den Empfänger übertragen wurden, vor Datenblöcken, die an den Empfänger übertragen wurden, platziert.

Ausgehend von einem Polynom f(x) mit dem Grad $n + r - 1 = n + r_A + r_B - 1$ bedeutet dies, dass die Blöcke wie folgt platziert werden:

- Die höchsten $r_A$ x-Potenzen von f(x) (also von $x^{n+r-1}$ bis $x^{n+r_B}$) repräsentieren die "A"-Blöcke, also diejenigen Blöcke, welche an den Empfänger nicht übertragen werden bzw. wurden, da sie ihm bekannt sein sollten.

- Die nächsten $r_B$ x-Potenzen von f(x) (also von $x^{n+r_B-1}$ bis $x^n$) repräsentieren die "B"-Blöcke, also diejenigen Blöcke, welche an den Empfänger übertragen werden bzw. wurden.

- Die niedrigsten n x-Potenzen von f(x) (also von $x^{n-1}$ bis $x^0$) repräsentieren die CRC-Bits, welche auch an den Empfänger übertragen werden bzw. wurden.

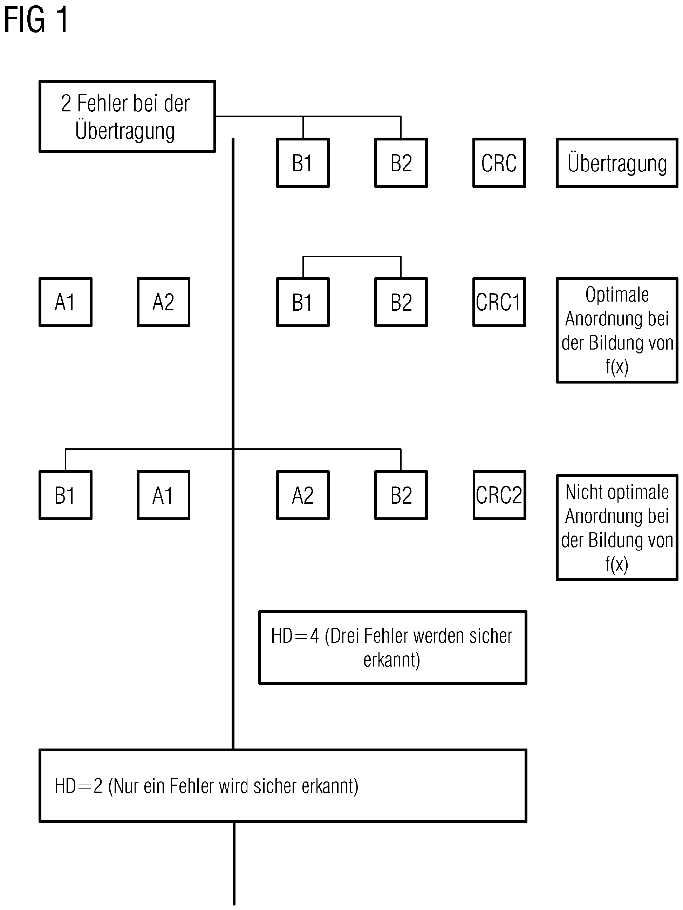

Dieser Zusammenhang ist im Folgenden beispielhaft anhand der FIG 1 erläutert.

Die Nachricht M besteht aus den Blöcken A1, A2, B1 und B2. Es folgt die Bildung des Polynoms f(x) und die Bestimmung der CRC-Bits. Der Wert des CRC-Blocks, welcher von allen Datenblöcken ("A" und "B") beeinflusst wird, hängt auch von der Reihenfolge der Datenblöcke bei der Bildung des Polynoms f(x) ab, daher auch die Bezeichnungen "CRC1" und "CRC2" in der Figur. An den Empfänger R werden die Blöcke B1 und B2 sowie der entsprechende CRC-Block abgeschickt (siehe erste Reihe in der FIG 1).

Im Beispiel der FIG 1 kommt es bei der Übertragung zu zwei Fehlern (siehe markierte Stellen). Ist es in der Tat so, dass das Generatorpolynom eine 3-Fehlergarantie liefert (HD = 4) für eine Nachrichtenlänge von 2 Datenblöcken + CRC-Block aber nur eine 1-Fehlergarantie (HD = 2) für eine Nachrichtenlänge von 4 Datenblöcken + CRC-Block, dann kann folgende Situation entstehen:

- War bei der Bildung des Polynoms f(x) die Anordnung der Datenblöcke optimal, dann befinden sich diese Fehler im HD = 4-Bereich, sie werden also aufgedeckt (siehe zweite Reihe in der FIG 1).

- War bei der Bildung des Polynoms f(x) die Anordnung der Datenblöcke nicht optimal, dann befinden sich diese Fehler im HD = 2-Bereich, sie können also unaufgedeckt bleiben und eine fehlerhaft angekommene Sendung kann durch die falsche Anordnung der Blöcke als richtig akzeptiert werden (siehe dritte Reihe in der FIG 1).

Die optimale Anordnung minimiert innerhalb des Polynoms f(x) die tatsächliche reale Länge der zu schützenden Nachricht (also die Länge zwischen dem höchstsignifikanten Bit der "B"-Blöcke und dem niedrigsten Bit des CRC-Blocks). Jede andere Anordnung hätte zur Folge eine unnötige Verlängerung des Abstands zwischen dem höchstsignifikanten Bit der "B"-Blöcke und dem niedrigsten Bit des CRC-Blocks) und somit eine potenzielle Schwächung des CRC-Schutzes, welche sich mittels einer niedrigeren HD ausdrücken würde.

Durch die vorstehend erläuterte Anordnung wird erreicht, dass die "B"-Blöcke, also die Blöcke, die übertragen werden, den maximalen CRC-Schutz genießen. So wie sie platziert sind, gilt für sie die Aussage der HD, nämlich, dass bis zu HD-1 Fehlern mit absoluter Sicherheit erkannt werden. Jede andere Platzierung der "A"- bzw. "B"-Blöcke hätte dazu geführt, dass mindestens Teile eines "B"-Blocks weiter weg als $r_B$ Bits vom CRC-Bitblock wären und somit hätte die HD sicher einen nicht größeren Wert (mit großer Wahrscheinlichkeit wäre der Wert kleiner) und somit wäre der Integritätsschutz auch nicht größer (mit großer Wahrscheinlichkeit wäre er kleiner). Durch die vorstehend erläuterte Anordnung der Blöcke ist somit ein optimaler Schutz gegeben.

Die Erfindung wendet sich dabei ab von einem bisher bekannten Lösungsansatz, der darin besteht, mit Hilfe sogenannter "punktierter Codes" die "A"-Blöcke bei der Codierung zu "streichen". Im Unterschied hierzu fließen bei vorliegender Erfindung aber die "A"-Blöcke mit in die Bildung von f(x) ein.

Die nicht an den Empfänger zu übertragenden bzw. übertragenen Datenblöcke sind dabei keine nur dem Empfänger und dem Sender bekannte geheime Information. Sie können beispielsweise eine oder mehrere Busadresse(n) und/oder eine oder mehrere Gerätekennung(en) des Empfängers der Daten repräsentieren.

Die an den Empfänger zu übertragenden bzw. übertragenen Datenblöcke können Nutzdaten und/oder eine oder mehrere laufende Nummer(n) repräsentieren.

Eine besonders vorteilhafte Verwendung des Verfahrens liegt in der Feldbus-Kommunikation, insbesondere einer Feldbus-Kommunikation nach dem AS-Interface-Standard.

Das AS-Interface (abgekürzt AS-i für engl. Actuator-Sensor-Interface; deutsch Aktor-Sensor-Schnittstelle) ist ein Standard für die Feldbus-Kommunikation, der zum Anschluss von Aktoren und Sensoren entwickelt worden ist. Ziel ist es, eine Parallelverkabelung zu ersetzen. Das AS-Interface wird dabei hauptsächlich auf der Sensor-/Aktuatorebene eingesetzt. Das AS-Interface ist seit 1999 internationaler Standard nach EN 50295 und IEC 62026-2.

Eine erfindungsgemäße Sendevorrichtung für Daten bzw. Nachrichten ist derart ausgebildet, dass sie einen CRC-Wert mit dem vorstehend erläuterten Verfahren bildet.

Eine erfindungsgemäße Empfangsvorrichtung für Daten bzw. Nachrichten ist ebenfalls derart ausgebildet, dass sie einen CRC-Wert mit dem vorstehend erläuterten Verfahren bildet.

Ein erfindungsgemäßes Master-Gerät für eine Feldbus-Kommunikation, insbesondere eine Feldbus-Kommunikation nach dem AS-Interface-Standard, umfasst eine derartige Sendevorrichtung. Ein erfindungsgemäßes Slave-Gerät für eine Feldbus-Kommunikation, insbesondere eine Feldbus-Kommunikation nach dem AS-Interface-Standard, umfasst eine derartige Empfangsvorrichtung.

Für den Fall einer bidirektionalen Datenübertragung zwischen Master-Gerät und Slave-Gerät kann das Master-Gerät zusätzlich auch noch eine erfindungsgemäße Empfangsvorrichtung und umgekehrt das Slave-Gerät zusätzlich auch noch eine erfindungsgemäße Sendevorrichtung aufweisen.

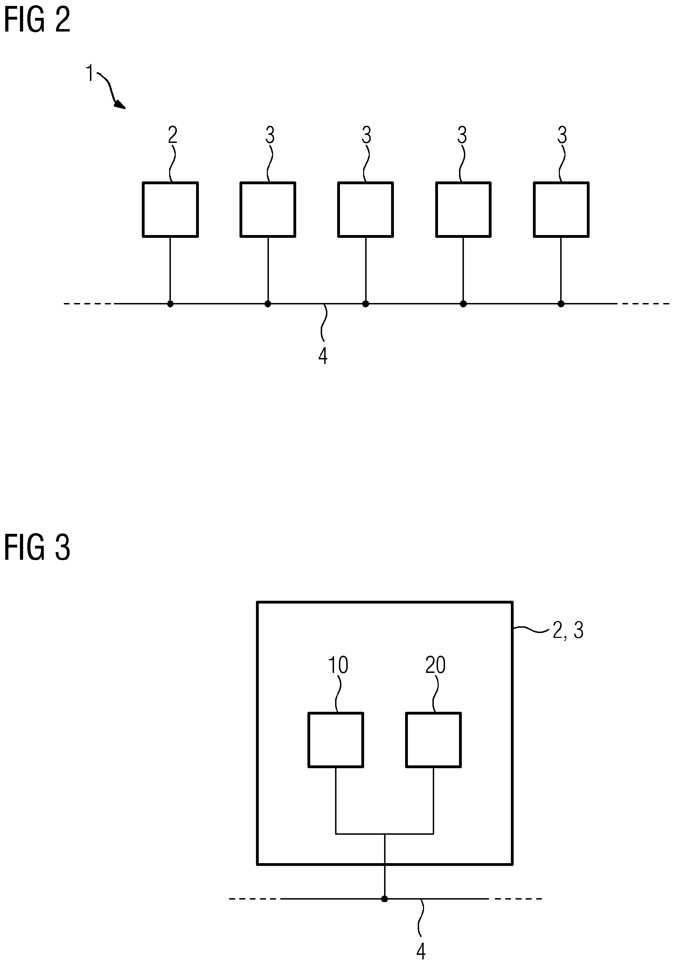

Die Erfindung sowie weitere vorteilhafte Ausgestaltungen der Erfindung gemäß Merkmalen der Unteransprüche werden im Folgenden noch anhand von Ausführungsbeispielen in den Figuren 2 bis 4 näher erläutert.

FIG 2 zeigt ein in vereinfachter und prinzipieller Darstellung ein Blockschaltbild eines beispielhaften Feldbus-Kommunikationssystems 1, insbesondere eines Feldbus-Kommunikationsystems nach dem AS-Interface-Standard, zum Ablauf des im Zusammenhang mit FIG 1 erläuterten erfindungsgemäßen Verfahrens. Grundsätzlich sind als Übertragungsstrecke jedoch ein beliebiges Netzwerk, beispielsweise Ethernet, oder beliebige andere drahtgebundene Übertragungsstrecken bzw. Netzwerke, aber auch drahtlose Übertragungsstrecken bzw. Netzwerke, beispielsweise WLAN, möglich.

Das Kommunikationssystems 1 umfasst dabei ein Master-Gerät 2 (häufig auch nur einfach als "Master" bezeichnet) und mehrere Slave-Geräte 3 (häufig auch nur einfach als "Slaves" bezeichnet), die über einen Feldbus 4 miteinander verbunden sind. Über den Feldbus 4 ist eine bidirektionale Datenübertragung von dem Master-Gerät 2 an die Slave-Geräte 3 und umgekehrt von den Slave-Geräten 3 an das Master-Gerät 2 möglich.

Das Master-Gerät 2 steuert das logische und zeitliche Verhalten auf dem Feldbus 4. Die Slave-Geräte 3 werden vom Master-Gerät 2 zyklisch über ihre Busadresse angesprochen und generieren auch nur dann eine Antwort an das Master-Gerät, wenn sie von dem Master-Gerät angesprochen werden. Die Slave-Geräte 3 sind beispielsweise in Sensoren oder Aktoren integriert.

Wie im Detail in FIG 3 in vereinfachter und prinzipieller Darstellung gezeigt, weist sowohl das Master-Gerät 2 als auch jedes der Slave-Geräte 3 jeweils eine Sendevorrichtung 10 und eine Empfangsvorrichtung 20 auf. Die Sendevorrichtung 10 und die Empfangsvorrichtung 20 können auch in einer einzigen kombinierten Sende-/Empfangsvorrichtung zusammengefasst sein.

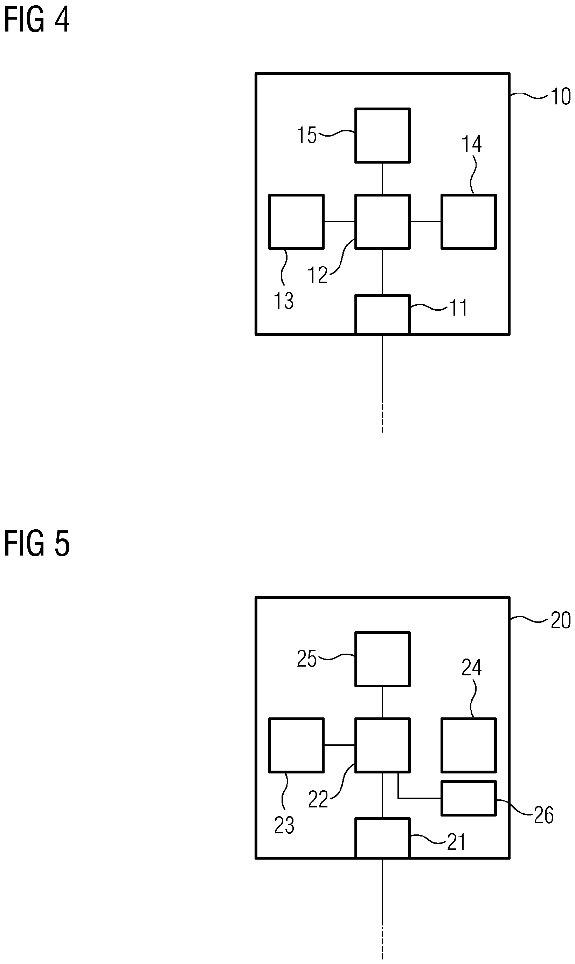

Gemäß FIG 4 umfasst die Sendevorrichtung 10 eine Sendeeinheit 11, eine Berechnungseinheit 12, einen Speicher 13 für zu übertragende Nutzdaten ("B-Blöcke"), einen Speicher 14 für nicht zu übertragende Daten ("A-Blöcke"), die dem Empfänger bereits bekannt sind, und zumindest ein Schieberegister 15 mit geeigneten Rückkopplungen.

Durch die Berechnungseinheit 12 wird mit Hilfe des zumindest einen Schieberegisters 15 aus den in den Speichern 14 und 15 hinterlegten Daten ein CRC-Wert gebildet, wobei für die Bildung des CRC-Wertes die Datenblöcke A, die nicht an eine Empfangsvorrichtung 20 übertragen werden, vor den Datenblöcken B, die an eine Empfangsvorrichtung 20 übertragen werden, platziert werden. Anschließend fügt die Berechnungseinheit 12 die Blöcke B sowie den generierten CRC-Wert zu einer Nachricht M zusammen und übergibt diese an die Sendeeinheit 11, die sie in entsprechende analoge elektrische Signale umwandelt und diese in den Feldbus 4 einspeist.

Die Empfangsvorrichtung 20 umfasst gemäß FIG 5 eine Empfangseinheit 21, eine Berechnungs- und Auswerteeinheit 22, einen Speicher 23 für empfangene Nutzdaten ("B-Blöcke"), einen Speicher 24 für nicht übertragene Daten ("A-Blöcke"), die dem Empfänger bekannt sind, zumindest ein Schieberegister 25 und einen Speicher 26 für einen empfangenen CRC-Wert auf.

Durch die Empfangseinheit 21 wird eine über den Feldbus 4 in Form analoger elektrischer Signale empfangene Nachricht M in digitale Signale umgewandelt und an die Berechnungs- und Auswerteeinheit 22 übergeben. Diese zerlegt die Nachricht M in die B-Blöcke und den CRC-Wert. Die B-Blöcke werden in dem Speicher 23 und der CRC-Wert in dem Speicher 26 abgespeichert. Anschließend wird durch die Berechnungs- und Auswerteeinheit 22 mit Hilfe des zumindest einen Schieberegisters 15 aus den in dem Speicher 24 hinterlegten A-Blöcken und den in dem Speicher 23 abgelegten B-Blöcken ein CRC-Wert gebildet, wobei für die Bildung des CRC-Wertes die Datenblöcke A, die nicht von der Empfangsvorrichtung 20 empfangen wurden, vor den Datenblöcken B, die von der Empfangsvorrichtung 20 empfangen wurden, platziert werden. Anschließend werden von der Berechnungs- und Auswerteeinheit 22 der in dem Speicher 26 abgelegte und mit der Nachricht M empfangene CRC-Wert und der berechnete CRC-Wert verglichen und bei einer Abweichung auf einen Fehler in der Datenübertragung über den Feldbus 4 geschlossen. Als Reaktion darauf kann beispielsweise die Nachricht M verworfen werden.

**Patentansprüche**

1. Verfahren zur Bildung eines CRC-Wertes über mehrere Datenblöcke, wobei für die Bildung des CRC-Wertes Datenblöcke, die nicht an einen Empfänger übertragen werden bzw. nicht an einen Empfänger übertragen wurden, vor Datenblöcken, die an den Empfänger übertragen werden bzw. an den Empfänger übertragen wurden, platziert werden,
   **dadurch gekennzeichnet, dass** die Datenblöcke, die nicht an den Empfänger übertragen werden bzw. wurden, keine nur dem Empfänger und dem Sender bekannte geheime Informationen sind.

2. Verfahren nach Anspruch 1,
   wobei eine Nachricht M der Länge r Bits als ein Polynom $f(x)$ mit dem Grad $n + r - 1 = n + r_A + r_B - 1$ betrachtet wird, wobei $r_A$ die Länge in Bits der nicht an den Empfänger zu übertragenden bzw. übertragenen Datenblöcke und $r_b$ die Länge in Bits der an den Empfänger zu übertragenden bzw. übertragenen Datenblöcke ist, und wobei

   - die höchsten $r_A$ x-Potenzen von $f(x)$ (d.h. von $x^{n+r-1}$ bis $x^{n+r_B}$) die nicht an den Empfänger zu übertragenden bzw. übertragenen Datenblöcke repräsentieren,
   - die nächsten $r_B$ x-Potenzen von $f(x)$ (d.h. von $x^{n+r_B-1}$ bis $x^n$) die an den Empfänger zu übertragenden bzw. übertragenen Datenblöcke repräsentieren und
   - die niedrigsten n x-Potenzen von $f(x)$ (d.h. von $x^{n-1}$ bis $x^0$) die CRC-Bits repräsentieren, welche auch an den Empfänger übertragen werden bzw. wurden.

3. Verfahren nach einem der vorhergehenden Ansprüche, wobei die nicht an den Empfänger zu übertragenden Datenblöcke eine oder mehrere Busadresse(n) und/oder eine oder mehrere Gerätekennung(en) repräsentieren.

4. Verfahren nach einem der vorhergehenden Ansprüche, wobei die an den Empfänger zu übertragenden Datenblöcke Nutzdaten und/oder eine oder mehrere laufende Nummer(n) repräsentieren.

5. Verwendung des Verfahrens nach einem der vorhergehenden Ansprüche für eine Feldbus-Kommunikation, insbesondere eine Feldbus-Kommunikation nach dem AS-Interface-Standard.

6. Sendevorrichtung (10), die derart ausgebildet ist, dass sie einen CRC-Wert mit einem Verfahren nach einem der Ansprüche 1 bis 4 bildet.

7. Empfangsvorrichtung (20), die derart ausgebildet ist, dass sie einen CRC-Wert mit einem Verfahren nach einem der Ansprüche 1 bis 4 bildet.

8. Master-Gerät (2) für eine Feldbus-Kommunikation, insbesondere eine Feldbus-Kommunikation nach dem AS-Interface-Standard, **dadurch gekennzeichnet, dass** es eine Sendevorrichtung (10) nach Anspruch 6, vorzugsweise zusätzlich auch noch eine Empfangsvorrichtung (20) nach Anspruch 7, umfasst.

9. Slave-Gerät (3) für eine Feldbus-Kommunikation, insbesondere eine Feldbus-Kommunikation nach dem AS-Interface-Standard, **dadurch gekennzeichnet, dass** es eine Empfangsvorrichtung (20) nach Anspruch 7, vorzugsweise zusätzlich auch noch eine Sendevorrichtung (10) nach Anspruch 6, umfasst.

**Claims**

1. Method for forming a CRC value using a plurality of data blocks, wherein, when forming the CRC value, data blocks which are not or were not transmitted to a receiver are placed in front of data blocks which are or were transmitted to the receiver, **characterised in that** the data blocks which are not or were not transmitted to the receiver are not confidential information known only to the receiver and the sender.

2. Method according to claim 1, wherein a message M of the length r bits is considered as a polynomial $f(x)$ having degree $n+r-1=n+r_A+r_B-1$, where $r_A$ is the length in bits of the data blocks which are not to be or were not transmitted to the receiver and $r_b$ is the length in bits of the data blocks which are to be or were transmitted to the receiver, and wherein

   - the highest $r_A$ x-powers of $f(x)$ (i.e. from $x^{n+r-1}$ to $x^{n+r_B}$) represent the data blocks which are not to be or were not transmitted to the receiver,
   - the next $r_B$ x-powers of $f(x)$ (i.e. from $x^{n+r_B-1}$ to $x^n$) represent the data blocks which are to be or were transmitted to the receiver, and
   - the lowest n x-powers of $f(x)$ (i.e. from $x^{n-1}$ to $x^0$) represent the CRC bits, which are also or were also transmitted to the receiver.

3. Method according to one of the preceding claims, wherein the data blocks which are not to be transmitted to the receiver represent one or more bus address(es) and/or one or more device identifier(s).

4. Method according to one of the preceding claims, wherein the data blocks which are to be transmitted to the receiver represent payload data and/or one or more sequential number(s).

5. Use of the method according to one of the preceding claims for field bus communication, in particular for field bus communication according to the AS-Interface standard.

6. Transmitting apparatus (10) which is so designed as to form a CRC value using a method according to one of claims 1 to 4.

7. Receiving apparatus (20) which is so designed as to form a CRC value using a method according to one of claims 1 to 4.

8. Master device (2) for field bus communication, in particular for field bus communication according to the AS-Interface standard, **characterised in that** it comprises a transmitting apparatus (10) according to claim 6 and preferably also a receiving apparatus (20) according to claim 7.

9. Slave device (3) for field bus communication, in particular for field bus communication according to the AS-Interface standard, **characterised in that** it comprises a receiving apparatus (20) according to claim 7 and preferably also a transmitting apparatus (10) according to claim 6.


**Revendications**

1. Procédé de formation d'une valeur CRC par plusieurs blocs de données, dans lequel, pour la formation de la valeur CRC, on place des blocs de données, qui ne sont pas transmis à un récepteur ou qui n'ont pas été transmis à un récepteur, avant des blocs de données, qui sont transmis au récepteur ou qui ont été transmis au récepteur, **caractérisé en ce que** les blocs de données, qui ne sont pas transmis ou qui n'ont pas été transmis au récepteur, ne sont pas des informations secrètes connues seulement du récepteur et de l'émetteur.

2. Procédé suivant la revendication 1, dans lequel on considère un message M d'une longueur de r bits sous la forme d'un polynôme $f(x)$ de degré $n+r-1=n+r_A+r_B-1$, $r_A$ étant la longueur en bits des blocs de données, qui ne sont pas transmis ou qui n'ont pas été transmis au récepteur, et $r_b$ la longueur en bits des blocs de données à transmettre ou qui ont été transmis au récepteur, et dans lequel

EP 2 764 647 B1

- les $r_A$ puissances de x les plus grandes de f(x) (c'est-à-dire de $x^{n+r-1}$ à $x^{n+r}B$) représentent les blocs de données, qui ne sont pas à transmettre ou qui n'ont pas été transmis au récepteur,
- les $r_B$ puissance de x venant immédiatement ensuite de f(x) (c'est-à-dire de $x^{n+r}B^{-1}$ à $x^n$) représentent les blocs de données à transmettre ou transmis au récepteur et
- les n puissance x les plus petites de f(x) (c'est-à-dire de $x^{n-1}$ à $x^0$) représentent les bits CRC, qui sont transmis également au récepteur ou qui l'ont été.

3. Procédé suivant l'une des revendications précédentes,
dans lequel les blocs de données, qui ne sont pas à transmettre au récepteur représentent une ou plusieurs adresses de bus et/ou une ou plusieurs caractérisations d'appareil.

4. Procédé suivant l'une des revendications précédentes, dans lequel les blocs de données à transmettre au récepteur représentent des données utiles et/ou un ou plusieurs numéros courants.

5. Utilisation du procédé suivant l'une des revendications précédentes, pour une communication par bus sur site, notamment une communication par bus sur site suivant la norme d'interface AS.

6. Dispositif (10) d'émission, constitué de manière à former une valeur CRC par un procédé suivant l'une des revendications 1 à 4.

7. Dispositif (20) de réception, constitué de manière à former une valeur CRC par un procédé suivant l'une des revendications 1 à 4.

8. Appareil (2) maître pour une communication par bus sur site, notamment une communication par bus sur site suivant la norme d'interface AS, **caractérisé en ce qu'**il comprend un dispositif (10) d'émission suivant la revendication 6, de préférence supplémentairement également encore en plus un dispositif (20) de réception suivant la revendication 7.

9. Appareil (3) esclave pour une communication par bus sur site, notamment par une communication par bus sur site suivant la norme d'interface AS, **caractérisé en ce qu'**il comprend un dispositif (20) de réception suivant la revendication 7, de préférence supplémentairement également encore en plus un dispositif (10) d'émission suivant la revendication 6.

# FIG 1

| 2 Fehler bei der Übertragung | | B1 | B2 | CRC | Übertragung |
|---|---|---|---|---|---|

| A1 | A2 | B1 | B2 | CRC1 | Optimale Anordnung bei der Bildung von f(x) |
|---|---|---|---|---|---|

| B1 | A1 | A2 | B2 | CRC2 | Nicht optimale Anordnung bei der Bildung von f(x) |
|---|---|---|---|---|---|

HD=4 (Drei Fehler werden sicher erkannt)

HD=2 (Nur ein Fehler wird sicher erkannt)

## FIG 2

## FIG 3

## FIG 4

## FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004250061 A1, Yamauchi Hiroki
- DE 102007016917 A1